# EUROPEAN PATENT SPECIFICATION

(11) **EP 1 817 136 B1**
(45) Date of publication and mention of the grant of the patent: **08.04.2015**
(21) Application number: 05705554.3
(22) Date of filing: 12.01.2005
(51) Int. Cl.: B23K 31/02

(54) **PRINTED CIRCUIT BOARD CLAMP**
LEITERPLATTENKLEMME
DISPOSITIF D ALIGNEMENT DE CARTE DE CIRCUIT IMPRIME

(30) Priority: 12.11.2004 US 986949
(43) Date of publication of application: 15.08.2007
(73) Proprietor: DTG International GmbH, 8005 Zürich (CH)
(72) Inventor: MONCAVAGE, Charles, Bethlehem, PA 18017 (US)
(74) Representative: Boden, Keith McMurray
(86) International application number: PCT/US2005/000952
(87) International publication number: WO 2006/055015

(56) References cited:
- DE-A- 19 732 028
- US-A- 5 067 648
- US-A- 5 899 446

## Description

### BACKGROUND OF THE INVENTION

The manufacture of printed circuit (PC) boards typically entails soldering hardware components to a generally planar board. The board is transported along a plurality of stations where different processes are performed on the board and where different components are added to the board, depending upon the intended use of the board. At one station, the soldering station, a mask is disposed over the side of the board that is being printed, and molten solder is spread over the mask, depositing the solder onto the board through openings in the mask. The mask is removed and the board is advanced to the next stations, where other steps, such as the installation of components onto the hot solder, are performed upon the board.

It is important that the board be precisely located at the soldering station so that the solder is accurately deposited onto the board. U.S. Patent No. 5,899,446 to Thompson discloses a support that uses a vacuum to suck a PC board onto a PC board holder to fixedly secure the PC board during soldering operations. However, such a system requires a sealed environment bellow the PC board in order to obtain a vacuum, and components on the edges of the bottom face of the PC board may preclude such an environment. Further, such a system is dependent upon the operation of the vacuum system, which may be subject to breakdowns.

U.S. Patent No. 5,067,648 to Cascini discloses an apparatus for holding a PC board during soldering that requires individual and manual insertion of each PC board into the apparatus, severely limiting the ability to provide mass production of PC boards.

It would be beneficial to provide an apparatus to positively secure a PC board in a predetermined location, while providing the ability to mass produce numerous PC boards in a production line.

DE-A-19732028 discloses an automated apparatus for three-dimensional stack package devices, which includes a package loader/unloader for loading individual packages and unloading packages which have been stacked and soldered.

Briefly, the present invention provides a PC board clamp as claimed in claim 1. The clamp comprises a base member movable between a first position and a second position, a first lift rail mounted on the base member, and a second lift rail extending generally parallel to the first lift rail. The clamp also includes a first clamping member movably connected to the first lift rail and a second clamping member movably connected to the second lift rail. When the base member is in the first position, the first clamping member is disposed away from the first lift rail and the second clamping member is disposed away from the second lift rail and, when the base member is in the second position, the first clamping member is disposed proximate to the first rail and the second clamping member is disposed proximate to the second lift rail.

Further, the present invention also provides a PC board clamping assembly as claimed in claim 6. The assembly comprises a PC board conveyor rail assembly and a PC board clamp. The rail assembly comprises a first elongated conveyor rail member and a second elongated conveyor rail member spaced apart from the first elongated conveyor rail member. The second elongated conveyor rail extends generally parallel to the first elongated conveyor rail member. The PC board clamp includes a base member movable between a first position and a second position, a first lift rail mounted on the base member and extending generally parallel to the first elongated conveyor rail member, and a second lift rail extending generally parallel to the first lift rail. The PC board clamp also includes a first clamping member movably connected to the first lift rail, and a second clamping member movably connected to the second lift rail. When the base member is in the first position, the first lift rail is disposed below the first conveyor rail member and the second lift rail is disposed below the second conveyor rail member and, when the base member is in the second position, the first lift rail is disposed above the first conveyor rail member and the second lift rail is disposed above the second conveyor rail member.

Also, the present invention provides a method of securing a PC board to a fixture as claimed in claim 13.

The present invention also provides a method of automatically performing manufacturing processes on a plurality of PC boards as claimed in claim 19 and comprising providing a first PC board having a top face and a bottom face to a station; delivering the PC board on a conveyor to a predetermined location at the station; engaging the bottom face of the PC board with a lifting device; lifting the PC board from a first position to a second position, wherein a top clamp engages the top face during the lift between the first position and the second position, such that the PC board is securely retained between the top clamp and the lifting device; performing a manufacturing process on the top face; lowering the PC board to the conveyor, wherein the top clamp releases the PC board during the lowering; transporting the PC board away from the station; providing a subsequent PC board to the station; and repeating steps (b) though (h) automatically.

### BRIEF DESCRIPTION OF THE DRAWINGS

The accompanying drawings, which are incorporated herein and constitute part of this specification, illustrate the presently preferred embodiments of the invention, and, together with the general description given above and the detailed description given below, serve to explain the features of the invention. In the drawings:
Fig. 1 is front perspective view of a PC board clamping assembly, including a drive assembly, according to a preferred embodiment of the present invention.
Fig. 2 is an end elevational view of the PC board clamping assembly shown in Fig. 1, with a PC board in a lowered position, with the drive assembly removed for clarity.
Fig. 3 is an end elevational view of the PC board clamping assembly shown in Fig. 1, with the PC board in a raised position, with the drive assembly removed for clarity.
Fig. 4 is a rear perspective view of the PC board clamping assembly, with the drive assembly removed for clarity.

### DETAILED DESCRIPTION OF THE INVENTION

In the drawings, like numerals indicate like elements throughout. The terminology includes the words specifically mentioned, derivatives thereof and words of similar import. The embodiment illustrated below is not intended to be exhaustive or to limit the invention to the precise form disclosed. This embodiment is chosen and described to best explain the principle of the invention and its application and practical use and to enable others skilled in the art to best utilize the invention.

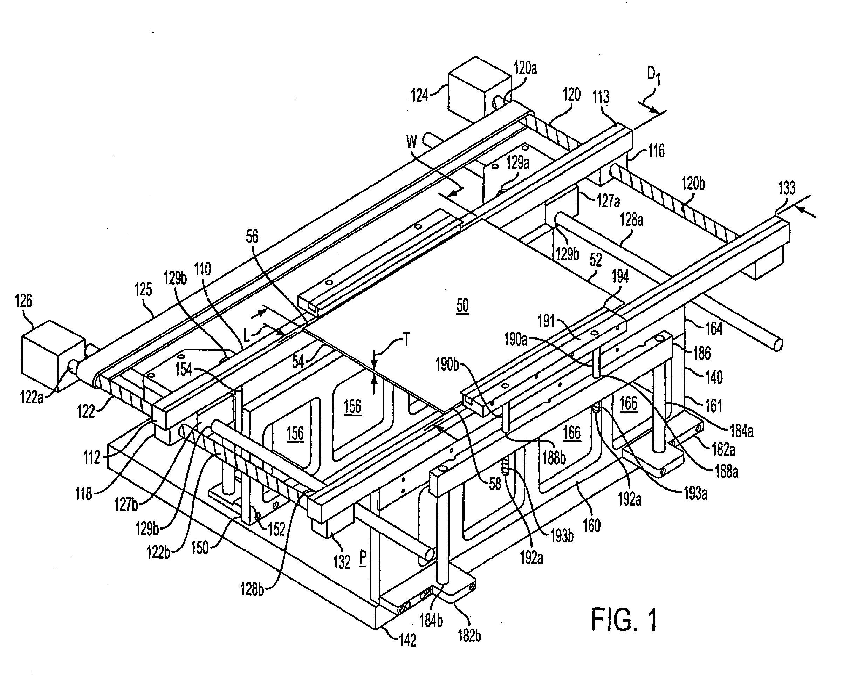

A clamping assembly 100 for use in securing a PC board 50 in a desired, fixed location is shown in Fig. 1. The clamping assembly 100 includes a conveyor rail assembly 110 that is used to laterally transport a PC board 50 during manufacturing operations and a PC board clamp 140 that is used to vertically transport to and to secure the PC board 50 at a processing station 62 during a specific manufacturing operation, such as solder screening. One such processing station 62 that performs solder screening is the MPM AP-25, manufactured by Speedline Technologies located in Franklin, Massachusetts. Alternatively, the processing station 62 may be used on other machines or for other processes, such as removal of components from the PC board 50 or rework of components on the PC board 50.

The conveyor rail assembly 110 may be integrally part of a PC board manufacturing station, while the PC board clamp 140 may be an add-on configuration that may be used to improve the operation of the PC board manufacturing station. Alternatively, the PC board clamp 140 maybe constructed integrally with the PC board manufacturing station, as well as the conveyor rail assembly 110.

The PC board 50 has a length "L", a thickness "W", and a thickness "T". The length L, the width W, and the thickness T may vary between PC boards, but the length L is typically between approximately 5.08 cm (2 inches) and 10.16 cm (4 inches), the width W is typically between approximately 10.16 cm (4 inches) and 12.70 cm (5 inches), and the thickness T is typically between approximately 0.10 cm (0.04") and 0.30 cm (0.12 inches). A common thickness T for the PC board 50 is approximately 0.16 cm (0.06 inches). However, those skilled in the art will recognize that the length L, the width W, and the thickness T may be dimensions outside those specified. The PC board 50 also has a top face 52 and a bottom face 54. Typically, a common surface area of each of the top face 52 and the bottom face 54 is approximately 110 cm² (15.5 in²).

The conveyor rail assembly 110 includes a first conveyor rail 112 and a second conveyor rail 132. A first conveyor belt 113 comprising a first endless loop extends along the first conveyor rail 112 and a second conveyor belt 133 comprising a second endless loop extends along the second conveyor rail 132. Preferably, the first conveyor belt 113 and the second conveyor belt 133 are each approximately 0.6 cm (0.24 inches) wide. A first end 56 of the PC board 50 rides along the first conveyor belt 113 and a second end 58 of the PC board 50 rides along the second conveyor belt 133 as the conveyor rail assembly 110 transports the PC board 50 into and out of the clamping assembly 100.

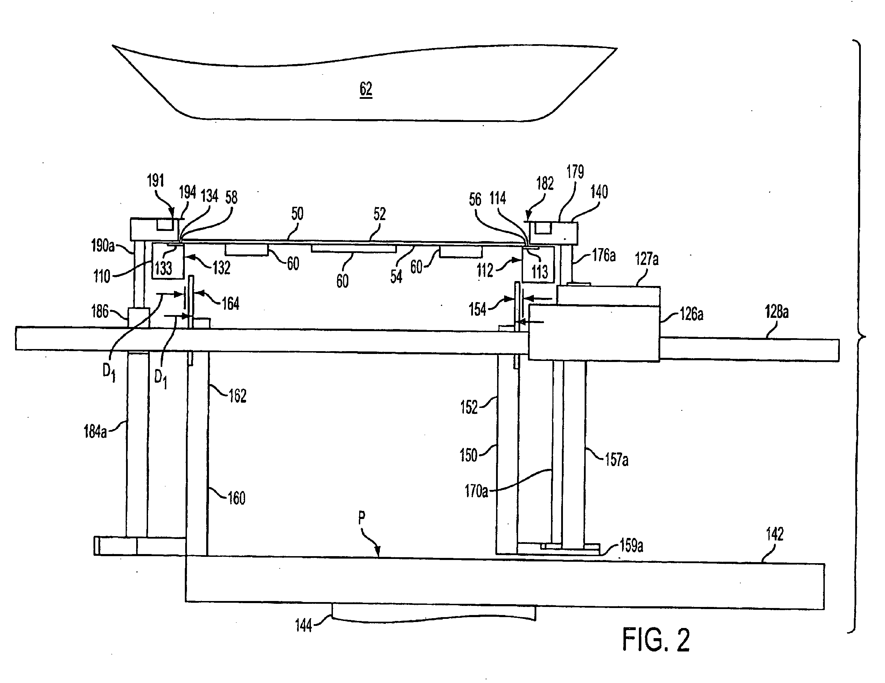

The first conveyor rail 112 includes a top face 114 and the second conveyor rail 132 includes a top face 134. The second conveyor rail 132 is parallel to the first conveyor rail 112 and is spaced apart from the first conveyor rail 112 by a predetermined distance Dₜ. Preferably, the distance D₁ is slightly less than the length L of the PC board 50 so that the PC board 50 rests on first and second conveyor belts 113, 33, respectively, as shown in Fig. 2.

The distance D₁ is adjustable by varying the location of the first conveyor rail 112 relative to the second conveyor rail 132. A translational mechanism, such as a screw thread, is used to translate the first conveyor rail 112 to a desired position. The first conveyor rail 112 includes first and second screw blocks 116, 118, respectively, that are disposed beneath and connected to the first conveyor rail 112. A screw 120, 122 is threaded through each screw block 116, 118, respectively. Each screw 120, 122 includes a first end 120a, 122a, respectively that is operatively connected to a drive mechanism 124 and a second end 120b, 122b that is rotatably supported to allow each screw 120, 122 to rotate with the drive mechanism 124. Preferably, the drive mechanism 124 is an electric motor, although those skilled in the art will recognize that other drive mechanisms, such as a hand crank, may be used instead of a motor. As seen in Fig. 1, the screw 120 is directly coupled to the drive mechanism 124, while the screw 122 is coupled to the drive mechanism 124 via an endless loop drive chain 125. Operation of the drive mechanism 124 rotates the screws 120, 122, which in turn translate the first conveyor rail 112 either closer to or farther from the second conveyor rail 132, depending upon the rotational direction of the drive mechanism 124.

The first conveyor rail 112 also includes first and second bearing blocks 126a, 126b, respectively, that are each disposed beneath and connected to the first conveyor rail 112. Each bearing block 126a, 126b is slidingly disposed along a rail 128a, 128b, respectively, to support the first conveyor rail 112 and to maintain the parallel relationship of the first conveyor rail 112 relative to the second conveyor rail 132 during and after movement of the first conveyor rail 112.

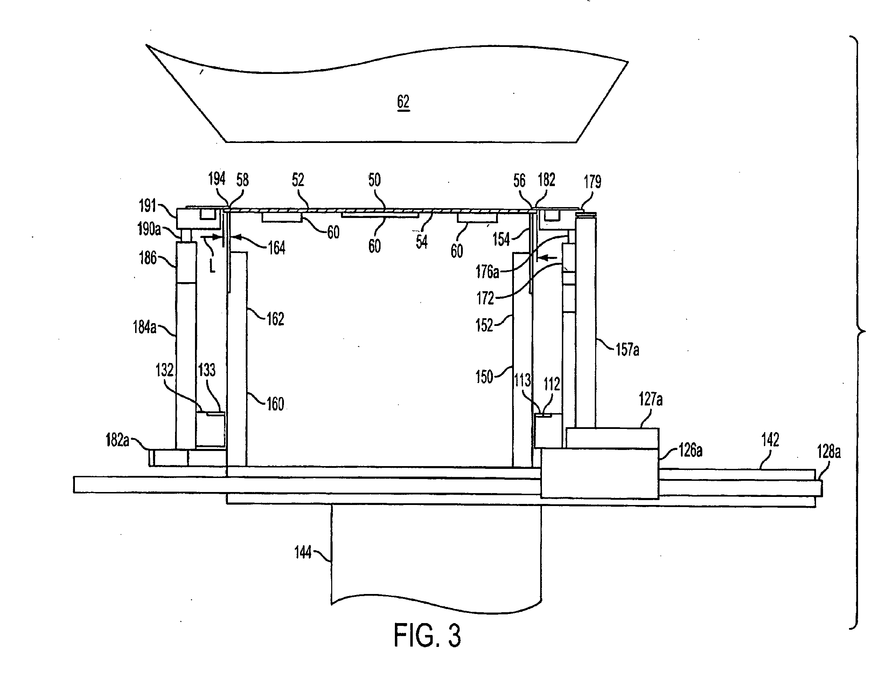

The PC board clamp 140 includes a tooling support table 142 extending in a plane "P", that is movably disposed below the conveyor rails 112, 132. The tooling support table 142 is movable between a first, or lower position, as shown in the end view of the assembly 100 in Fig. 2, and a second, or upper position, as shown in the end view of the assembly in Fig. 3. The tooling support table 142 is preferably moved by a lift screw 144. While one lift screw 144 is shown, those skilled in the art will recognize that more than one lift screw 144 may be used. The lift screw 144 is preferably driven by a servo or stepper motor to move the tooling support table 142 among a plurality of discrete positions, as will be discussed later in detail herein. Preferably, the lift screw 144 has an operating range of approximately 10.16 cm (4 inches).

The clamp 140 further includes a first board lift member 150 that includes a first base portion 152 and a first lift rail 154 that extends upward from the first base portion 152. The first board lift member 150 is disposed generally between the first conveyor rail 112 and the second conveyor rail 132. The first lift rail 154 preferably has a cross section of approximately 0.10 cm (0.04 inches). The first lift rail 154 supports the first end 56 of the PC board 50 during lifting and manufacturing operations. As seen in Fig. 2, the first lift rail 154 may be a separate component from the first base portion 152, with the first lift rail 154 being fixedly connected to the first base portion 152, such as by a screw connection. However, those skilled in the art will recognize that the first lift rail 154 may be integrally manufactured as an extension of the first base portion 152. In a preferred embodiment, the first base portion 152 is constructed from aluminum, while the first lift rail 154 is constructed from stainless steel, nickel, or some other suitable material that is connected to the first base portion 152 with a screw connection.

The clamp 140 also includes a second board lift member 160 that includes a second base portion 162 and a second lift rail 164 that extends upward from the second base portion 162. The second board lift member 160 is disposed generally between the first conveyor rail 112 and the second conveyor rail 132. The second lift rail 164 preferably has a width of approximately 0.10 cm (0.04 inches). The second lift rail 164 supports the second end 58 of the PC board 50 during lifting and manufacturing operations. Similar to the first board lift member 150, the second board lift member 160 may include the second lift rail 164 being a separate component from the second base portion 162, with the second lift rail 164 being fixedly connected to the second base portion 162, such as by a screw connection. However, those skilled in the art will recognize that the second lift rail 164 may be integrally manufactured as an extension of the second base portion 162. In a preferred embodiment, the second base portion 162 is constructed from aluminum or other suitable material, while the second lift rail 164 is constructed from stainless steel, nickel, or some other suitable material that is connected to the second base portion 162 with a screw connection.

The second lift rail 164 is generally parallel to the first lift rail 154 and extends a distance D₂ away from the first lift rail 154 a distance that is at least slightly less than the length L of the PC board 50 so that the first and second lift rails 154, 164 can support the PC board 50. As seen in Fig. 2, the distance D₂ is slightly less than the distance D₁. With the first and second lift rails 154, 164 supporting first and second ends 56, 58 of the PC board 50, the PC board 50 is able to be lifted from the conveyor rail assembly 110 and lifted toward the processing station 62, such as a soldering head, for a manufacturing step to be performed on the PC board 50.

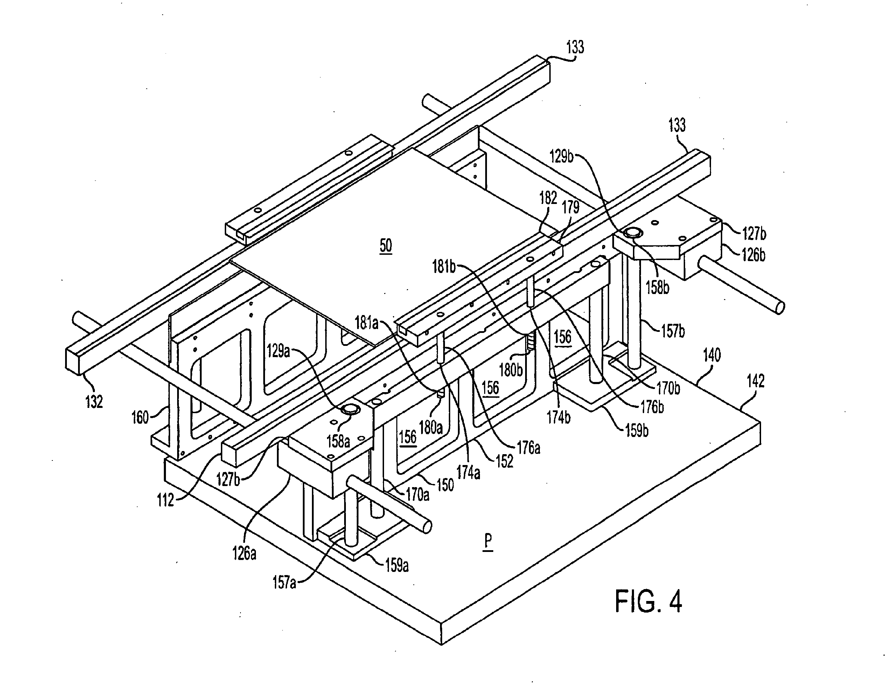

Further, as seen in Figs. 1 and 4 each of the base portions 152, 162 preferably include a plurality of cutouts 156, 166, respectively, to allow operator access to the space between the first and second board lift members 150, 160. The cutouts 156, 166 also serve to lighten the weight of each of the base portions 151,162, respectively, and allow light between the first and second base portions 152, 162 to allow an operator to more easily see between the base portions 152, 162.

Referring to Fig. 4, the first base portion 152 also includes bearing block mounts 127a, 127b that are mounted on top of each bearing block 126a, 126b, respectively. Each bearing block mount 127a, 127b overhangs beyond its respective bearing block 126a, 126b toward the other bearing block mount 127b, 127a. Each bearing block mount 127a, 127b includes a through hole 129a, 129b in the respective overhang to allow a guide post 157a, 157b, respectively, to extend therethrough. Each guide post 157a, 157b extends upward from the first base portion 152 and extends through the through holes 129a, 129b in the bearing block mounts 127a, 127b, respectively. The guide posts 157a, 157b allow the board clamp 140 to move vertically with respect to the conveyor rail assembly 110, yet allow the first board lift member 150 to traverse the tooling support table 142 toward and away from the second board lift member 160 as the first and second bearing blocks 126a, 126b move toward and away from the second board lift member 160 during operation of the drive mechanism 124. The top of each guide post 157a, 157b includes a C-clip 158a, 158b that supports each guide post 157a, 157b when the tooling support table 142 is in a lowered position.

A bottom portion of each guide post 157a, 157b is connected to a base 159a, 159b that is connected to the first base member 152. The bases 159a, 159b may be constructed separately from the first base member 152 and then fixedly connected to the first base member 152, such as by a threaded connection, or the bases 159a, 159b may alternatively be constructed integrally with the first base member 152. When the tooling support table 142 is in the lowered position, the guide posts 157a, 157b maintain the bases 159a, 159b and the first base member 152 approximately 0.127 cm (0.050 inches) above the tooling support table 142 to enable the bases 159a, 159b and the first base member 152 to traverse the tooling support table 142 during operation of the drive mechanism 124.

Each base 159a, 159b also includes a clamp support post 170a, 170b. The clamp support posts 170a, 170b each extend upward from the bases 159a, 159b, respectively, generally parallel to the guide posts 157a, 157b. The clamp support posts 170a, 170b support a first clamp rail 172 that extends parallel to the first conveyor rail 112. The first clamp rail 172 is situated such that the first conveyor rail 112 is disposed generally between the first lift rail 154 and the first clamp rail 172. The first clamp rail 172 includes two through holes 174a, 174b that are sized to allow clamp posts 176a, 176b to slide along the through holes 174a, 174b, respectively, with minimal resistance. The clamp posts 176a, 176b support a first clamp 179. Each clamp post 176a, 176b also includes a C-clip 180a, 180b, respectively, disposed at a lower end of each clamp post 176a, 176b. A helical spring 181a, 181b is disposed around each respective clamp post 176a, 176b between the C-clip 180a, 180b and the first clamp rail 172. The helical springs 181a, 181b bias the first clamp 179 toward the first clamp rail 172 and allow the first clamp 179 to travel approximately 2.54 cm (1 inch). The first clamp 179 includes a first lip 182 that extends from the top of the first clamp 179 generally toward the second conveyor rail 132. Preferably, the first lip 182 is approximately 0.018 cm (0.007 inches) thick and constructed from stainless steel. The first clamp 179 includes an elongated first steel stock 179a that is embedded in the first clamp 179. The first steel stock 179a is releasably connected to the first clamp 179, such as by screws (not shown). The first lip 182 is fixedly connected to the first steel stock 179a so that the first lip 182 may be readily replaced by removing the first steel stock 179a from the first clamp 179 and replacing with a replacement steel stock (not shown).

Referring back to Fig. 1, bases 182a, 182b each extend from the second base portion 162. Each base supports a clamp support post 184a, 184b. The clamp support posts 184a, 184b each extend upward from the bases 182a, 182b, generally parallel to the clamp support posts 170a, 170b. The clamp support posts 184a, 184b support a second clamp rail 186 that extends parallel to the second conveyor rail 132. The second clamp rail 186 is situated such that the second conveyor rail 132 is disposed generally between the second lift rail 164 and the second clamp rail 186. The second clamp rail 186 includes two through holes 188a, 188b that are sized to allow clamp posts 190a, 190b to slide along the through holes 188a, 188b, respectively, with minimal resistance. The clamp posts 190a, 190b support a second clamp 191. Each clamp post 190a, 190b also includes a C-clip 192a, 192b, respectively, disposed at a lower end of each clamp post 190a, 190b. A helical spring 193a, 193b is disposed around each respective clamp post 190a, 190b between the C-clip 192a, 192b and the second clamp rail 186. The helical springs 193a, 193b bias the second clamp 191 toward the second clamp rail 186 and allow the second clamp 191 to travel approximately 2.54 cm (1 inch). The second clamp 191 includes a second lip 194 that extends from the top of the second clamp 191 generally toward the first conveyor rail 112. Preferably, the second lip 194 is approximately 0.018 cm (0.007 inches) thick and constructed from stainless steel. The second clamp 191 includes an elongated second steel stock 191a that is embedded in the second clamp 191. The second steel stock 191a is releasably connected to the second clamp 191, such as by screws (not shown). The second lip 194 is fixedly connected to the second steel stock 191a so that the second lip 194 may be readily replaced by removing the second steel stock 191 from the second clamp 191 and replacing with a replacement steel stock (not shown).

The distance between the first and second lips 182, 194, respectively is at least slightly less than the length L of the PC board 50, as is shown in Fig. 3. This distance allows the first and second lips 182, 194, respectively, to engage the top face 52 of the PC board 50 when the PC board 50 is brought into contact with the first and second lips 182, 194, as will be discussed in more detail later herein.

Optionally, a compliant locking support fixture, such as the fixture disclosed in U.S. Patent No. 6,702,272 to Moncavage, may be disposed on the tooling support table 142 between the first and second base portions 152, 162, respectively, and used to support the PC board 50 from underneath during the soldering process. However, those skilled in the art will recognize that other methods for supporting the PC board 50 from underneath may be used and that, for particularly small PC boards, the support from underneath may be omitted entirely.

Prior to operation of the PC board clamp 140, the spacing of the conveyor rails 112, 132 are set by operating the drive mechanism 124. The drive mechanism 124 rotates the screw 120, which in turn rotates the screw 122 via the endless loop 125. The screws 120, 122 rotate in the same direction, driving the screw blocks 116, 118 in a desired direction, either toward or away from the second conveyor rail 132. Since the screw blocks 116, 118 are fixedly connected to the first conveyor rail 112, the first conveyor rail 112 is thusly moved either toward or away from the second conveyor rail 132. The bearing blocks 126a, 126b also travel with the first conveyor rail 112. Since the first base portion 152 is operatively connected to the bearing blocks 126a, 126b through the bearing block mounts 127a, 127b, the guide posts 157a, 157b and their respective bases 159a, 159b, the first base portion 152 also moves with the first conveyor rail 112. At this time, the tooling support table 142 is in a lowered position, and the first base portion 152 and the 159a, 159b are suspended above the tooling support table 142 and are free to move over the tooling support table 142 without interference.

When the conveyor rails 112, 132 are spaced apart such that the distance between the first conveyor rail 112 and the second conveyor rail 132 is slightly smaller (approximately 0.3 cm), than the length L of the PC board 50, the drive mechanism 124 is stopped. The PC board 50, or a series of PC boards 50, all having the same length L, are able to be loaded onto the conveyor assembly 110, from the lower left hand side of the page of Fig. 1.

At this time, the tooling support table 142 is in a lowered position, as shown in Fig. 2. Each of the first and second clamps 179, 191, is resting on a respective top face 114, 134 of the first and second conveyor rail 112, 132. The PC board 50 is transported to the clamping assembly 100 by the conveyor belts 113, 133, with the first and second ends 56, 58 of the PC board 50 resting on first and second conveyor belts 113, 133, respectively. The PC board 50 moves onto the clamping assembly 100, from lower left toward upper right as shown in Fig. 1. The PC board 50 may have components 60 already affixed to the bottom of the board, as shown in Figs. 2 and 3, or the PC board 50 may not have any components affixed to the bottom of the PC board 50.

When the PC board 50 travels to a predetermined position between the first and second lift rails 154, 164 and the first and second lips 182, 194, respectively, the conveyor assembly 110 stops. The tooling support table 142 is vertically translated toward PC board 50 by activating the lift screw 144. Since the second base portion 162 is already disposed on the tooling support table 142, the second base portion 162 begins to move upward with the tooling support table 142. The tooling support table 142 traverses the space between the tooling support table 142 and the bottom of the first base portion 152 and the bases 159a, 159b and begins to lift the first base portion 162 and the bases 159a, 159b toward the PC board 50.

As the base portions 152, 162 are further lifted, the lift rails 154, 164 engage the PC board 50 at the bottom face 54 proximate to each of the first and second ends 56, 58, respectively, and lift the PC board 50 from the conveyor rails 112, 132. As the tooling support table 142 is further lifted toward the PC board 50, the clamp rails 172, 186 are lifted upward with the tooling support table 142. However, the clamps 179, 191 remain seated on top of their respective conveyor rails 112, 132, as the clamp posts 176a, 176b, 190a, 190b slide through their respective through holes 174a, 174b, 188a, 188b as the tooling support table 142 is being lifted.

When the first and second lift rails 154, 164 engage the bottom face 54 of the PC board 50, the first and second lift rails 154, 164 lift the PC board 50 from the conveyor rails 112, 132. The first and second lift rails 154, 164 lift the PC board 50 until the top face 52 of the PC board 50, proximate to each of the first and second ends 56, 58, respectively, engages each of the first and second lips 182,194 of the first and second clamps 179, 191, respectively. The springs 180a, 180, 192a, 192b bias the respective first and second clamps, 179, 191 toward a downward position, clamping the PC board 50 between the first and second clamps 179, 191 and the first and second lift rails 154, 164, securing the PC board 50 in the clamp 140. When the PC board 50 is securely clamped to the board clamp 140, the lift screw 144 stops to allow a camera (not shown) to enter the space between the PC board 50 and the processing station 62 to confirm proper alignment of the PC board 50 with respect to the processing station 62. If the PC board 50 is not properly aligned with the processing station 62, the processing station 62 may self-adjust to provide proper alignment Alternatively, the clamping assembly 100 may self-adjust via x, y, and theta positioning hardware (not shown) in order to provide proper alignment of the PC board 50 with the processing station 62.

After the camera confirms proper location of the PC board 50 with respect to the processing station 62, the lift screw 144 reactivates, and the first and second lift rails 154, 164 continue to lift the PC board 50 upward to the processing station 62, where a manufacturing step, such as solder application, is performed on the PC board 50.

After the manufacturing step is performed on the PC board 50, the lift screw 144 lowers the tooling support table 142 back toward the initial position. The first and second clamps 179, 191 are lowered onto the first and second lift rails 112, 132, respectively, and the PC board 50 is released from the clamp lips 182, 194. The first and second lift rails 154, 164 continue to lower the PC board 50 until the PC board 50 is lowered onto the first and second conveyor belts 113, 133. The lift screw 144 continues to lower the tooling support table 142 until the tooling support table 142 returns to its original position. The conveyor assembly 110 transports the PC board 50 away from the clamping assembly 100 and to the next station in line for manufacturing. The next PC board 50 is delivered to the clamping assembly 100 by the first and second conveyor belts 113, 133, and the process is repeated for the next PC board 50.

Preferably, the cycling time of the conveyor assembly 110 and the clamping assembly 100 between adjacent PC boards 50 in a production run is between approximately 2 and 4 seconds, and ore preferably, approximately 3 seconds, although those skilled in the art will recognize that the cycling time may be more or less than that timeframe.

Preferably, the clamping assembly 100 is electronically connected to a controller (not shown) such that the conveyor rail assembly 110 and the lift screw 144 automatically operate to transport PC boards 50 to the PC board clamp 140, to lift each PC board 50 from the conveyor rail assembly 110 to the processing station 62 for operation, to lower each PC board 50 back to the conveyor rail assembly 110, and to transport each PC board 50 to the next station for operation.

It will be appreciated by those skilled in the art that changes could be made to the embodiments described above without departing from the broad inventive concept thereof. It is understood, therefore, that this invention is not limited to the particular embodiments disclosed, but it is intended to cover modifications within the spirit and scope of the present invention as defined by the appended claims.

## Claims

1. A PC board clamp for clamping a PC board (50), comprising:
a base member (142) movable between a first position and a second position;
a first lift rail (154) operative to lift and engage the PC board (50) and mounted on the base member (142);
a second lift rail (164) operative to engage and lift the PC board (50) and extending generally parallel to the first lift rail (154);
**characterized in that** the PC board clamp further comprises:
a first clamping member (179) movably connected to the first lift rail (154); and
a second clamping member (191) movably connected to the second lift rail (132);
wherein, when the base member (142) is in the first position, the first clamping member (179) is disposed away from the first lift rail (154) and the second clamping member (191) is disposed away from the second lift rail (164) such as to receive the PC board (50) therebetween, and, when the base member (142) is in the second position, the first clamping member (179) is disposed proximate to the first lift rail (154) and the second clamping member (191) is disposed proximate to the second lift rail (164) such that the PC board (50) is clamped by and between the first clamping member (179) and the first lift rail (154) and the second clamping member (191) and the second lift rail (164).

2. The PC board clamp according to claim 1, further comprising:
a first clamping member support (170a) mounted to the first lift rail (154),
wherein the first clamping member (179) is movably connected to the first clamping member support (170a).

3. The PC board clamp according to claim 1, further comprising:
a second clamping member support (184a) mounted to the second lift rail (164),
wherein the second clamping member (191) is movably connected to the second clamping member support (184a).

4. The PC board clamp according to claim 1, wherein the first clamping member (179) is vertically movable relative to the base member (142).

5. The PC board clamp according to claim 1, wherein the base member (142) comprises a plane (P) and the first lift rail (154) is movable over the plane (P).

6. A PC board clamping assembly, comprising:
the PC board clamp according to any of claims 1 to 5; and
a PC board conveyor rail assembly, including:
a first elongate conveyor rail member (112) extending generally parallel to the first lift rail (154); and
a second elongate conveyor rail member (132) spaced apart from and extending generally parallel to the first conveyor rail member (112);
wherein, when the base member (142) is in the first position, the first lift rail (154) is disposed below the first conveyor rail member (112) and the second lift rail (164) is disposed below the second conveyor rail member (132), and, when the base member (142) is in the second position, the first lift rail (154) is disposed above the first conveyor rail member (112) and the second lift rail (164) is disposed above the second conveyor rail member (132).

7. The PC board clamping assembly according to claim 6, wherein, when the base member (142) is in the first position, the first clamping member (179) is disposed proximate to the first conveyor rail member (112), and, when the base member (142) is in the second position, the first clamping member (179) is disposed distal from the first conveyor rail member (112).

8. The PC board clamping assembly according to claim 7 when appendant upon claim 2, wherein the first conveyor rail member (112) is disposed between the first clamping member support (170a) and the second conveyor rail member (132).

9. The PC board clamping assembly according to claim 6, wherein the first lift rail (154) is disposed between the first and second conveyor rail members (112, 132).

10. The PC board clamping assembly according to claim 6, wherein the first conveyor rail member (112) is movable in a first direction and the first lift rail (154) is movable with the first conveyor rail member (112).

11. The PC board clamping assembly according to claim 6, wherein the first clamping member (179) is vertically movable relative to the first conveyor rail member (112).

12. The PC board clamping assembly according to claim 6, wherein the first clamping member (179) is vertically movable relative to the first lift rail (154).

13. A method of securing a PC board (50) to a fixture, comprising the steps of:
providing a PC board (50) having a top face (52) and a bottom face (54);
delivering the PC board (50) to a predetermined location;
engaging the bottom face (54) of the PC board (50) with a lifting device; and
lifting the PC board (50) from a first position to a second position;
**characterized by**:
providing a top clamp for engaging the top face of the PC board (50);
the top clamp being disposed away from the top face (52) of the PC board (50) in the first position; and
the top clamp engaging the top face (52) of the PC board (50) during the lifting between the first position and the second position, such that the PC board (50) is securely retained between the top clamp and the lifting device.

14. The method according to claim 13, wherein the providing step comprises the step of:
providing the PC board (50) on first and second conveyor rail members (112, 132).

15. The method according to claim 14, wherein the lifting device comprises first and second lift rails (154, 164), and further comprising, prior to the providing step, the steps of:
adjusting a first spacing between the first and second conveyor rail members (112, 132); and
simultaneously adjusting a second spacing between the first and second lift rails (154, 164).

16. The method according to claim 13, further comprising, after the lifting step, the step of:
performing a manufacturing operation on the PC board (50).

17. The method according to claim 16, further comprising, after the manufacturing step, the step of:
lowering the PC board (50) to the first position.

18. The method according to claim 17, further comprising, simultaneously to the lowering step, the step of:
releasing the top clamp from the lifting device.

19. A method of automatically performing manufacturing processes on a plurality of PC boards (50), comprising the steps of:
(a) performing the method according to claim 13, wherein the PC board (50) is delivered on a conveyor to a predetermined location at a station;
(b) performing a manufacturing process on a top face (52) of the PC board (50);
(c) lowering the PC board (50) to the conveyor, wherein the top clamp releases the PC board (50) during the lowering;
(d) transporting the PC board (50) away from the station; and
(e) repeating steps (a) through (d) automatically on subsequent PC boards (50).

## Patentansprüche

1. Leiterplatten-Klemme zum Klemmen einer Leiterplatte (50), welche umfasst:
Ein Basiselement (142), welches zwischen einer ersten Position und einer zweiten Position bewegbar ist;
Eine erste Hubschiene (154), welche betriebsbereit ist, die Leiterplatte (50) zu heben und in Eingriff zu bringen, und welche an dem Basiselement (142) befestigt ist;
Eine zweite Hubschiene (164), welche betriebsbereit ist, die Leiterplatte (50) in Eingriff zu bringen und zu heben und welche sich im Wesentlichen parallel zur ersten Hubschiene (154) erstreckt;
**dadurch gekennzeichnet, dass** die Leiterplatten-Klemme weiter umfasst:
ein erstes Klemmelement (179), das mit der ersten Hubschiene (154) bewegbar verbunden ist; und
ein zweites Klemmelement (191), das mit der zweiten Hubschiene (164) bewegbar verbunden ist;
worin, wenn sich das Basiselement (142) in der ersten Position befindet, das erste Klemmelement (179) weg von der ersten Hubschiene (154) und das zweite Klemmelement (191) weg von der zweiten Hubschiene (164) angeordnet ist, so dass die Leiterplatte (50) dazwischen aufgenommen wird, und wenn das Basiselement (142) sich in der zweiten Position befindet, das erste Klemmelement (179) nahe der ersten Hubschiene (154) angeordnet ist und das zweite Klemmelement (191) nahe der zweiten Hubschiene (164) angeordnet ist, so dass die Leiterplatte (50) durch und zwischen dem ersten Klemmelement (179) und der ersten Hubschiene (154) und dem zweiten Klemmelement (191) und der zweiten Hubschiene (164) geklemmt ist.

2. Leiterplatten-Klemme nach Anspruch 1, welche weiter umfasst:
Einen ersten Klemmelement-Träger (170a), der an die erste Hubschiene (154) befestigt ist, worin das erste Klemmelement (179) an den ersten Klemmelement-Träger (170a) bewegbar befestigt ist.

3. Leiterplatten-Klemme nach Anspruch 1, welche weiter umfasst:
Einen zweiten Klemmelement-Träger (184a), der an die zweite Hubschiene (164) befestigt ist, worin das zweite Klemmelement (191) mit dem zweiten Klemmelement-Träger (184a) bewegbar verbunden ist.

4. Leiterplatten-Klemme nach Anspruch 1, worin das erste Klemmelement (179) relativ zu dem Basiselement (142) vertikal bewegbar ist.

5. Leiterplatten-Klemme nach Anspruch 1, worin das Basiselement (142) eine Ebene (P) umfasst, und worin die erste Hubschiene (154) über die Ebene (P) bewegbar ist.

6. Leiterplattenklemm-Aufbau, welcher umfasst:
Eine Leiterplatten-Klemme nach einem der Ansprüche 1 bis 5; und
Ein Leiterplatten-Transportschienen-Aufbau, welcher umfasst:
Ein längliches Transportschienen-Element (132), das sich im Wesentlichen parallel zu der ersten Hubschiene (154) erstreckt; und
Ein zweites längliches Transportschienen-Element (132), das von ersten Transport-Schienenelement (112) beabstandet ist und sich im Wesentlichen parallel dazu erstreckt;
Worin wenn das Basiselement (142) sich in der ersten Position befindet, die erste Hubschiene (154) unter dem ersten Transport-Schienenelement (112) und die zweite Hubschiene (164) unter dem zweiten Transport-Schienenelement (132) angeordnet ist, und wenn das Basiselement (142) sich in der zweiten Position befindet, die erste Hubschiene (154) über dem ersten Transport-Schienenelement (112) und die zweite Hubschiene (164) über dem zweiten Transport-Schienenelement (132) angeordnet ist.

7. Leiterplattenklemm-Aufbau nach Anspruch 6, worin wenn das Basiselement (142) sich in der ersten Position befindet, das erste Klemmelement (179) nahe dem ersten Transport-Schienenelement (112) angeordnet ist, und wenn das Basiselement (142) sich in der zweiten Position befindet, das erste Klemmelement (179) distal von dem ersten Transport-Schienenelement (112) angeordnet ist.

8. Leiterplattenklemm-Aufbau nach Anspruch 7, wenn abhängig von Anspruch 2, worin das erste Transport-Schienenelement (112) zwischen dem ersten Klemmelement-Träger (170a) und dem zweiten Transport-Schienenelement (132) angeordnet ist.

9. Leiterplattenklemm-Aufbau nach Anspruch 6, worin die erste Hubschiene (154) zwischen dem ersten und zweiten Transport-Schienenelement (112, 132) angeordnet ist.

10. Leiterplattenklemm-Aufbau nach Anspruch 6, worin das erste Transport-Schienenelement (112) in eine erste Richtung bewegbar ist, und die erste Hubschiene (154) mit dem ersten Transport-Schienenelement (112) bewegbar ist.

11. Leiterplattenklemm-Aufbau nach Anspruch 6, worin das erste Klemmelement (179) relativ zu dem ersten Transport-Schienenelement (112) vertikal bewegbar ist.

12. Leiterplattenklemm-Aufbau nach Anspruch 6, worin das erste Klemmelement (179) relativ zu der ersten Hubschiene (154) vertikal bewegbar ist.

13. Verfahren zum Sichern einer Leiterplatte (50) an eine Befestigung, welches die Schritte umfasst:
Bereitstellen einer Leiterplatte (50) mit einer oberen Oberfläche (52) und einer unteren Oberfläche (54);
Liefern der Leiterplatte (50) an eine bestimmte Stelle;
In Eingriff bringen der unteren Oberfläche (54) der Leiterplatte (50) mit einer Hebeeinrichtung; und
Anheben der Leiterplatte (50) aus einer ersten Position in eine zweite Position;
gekennzeichnet durch :
Bereitstellen einer oberen Klemme zum Eingreifen der oberen Oberfläche der Leiterplatte (50);
worin die obere Klemme in der ersten Position weg von der oberen Oberfläche (52) der Leiterplatte (50) angeordnet ist; und
worin die obere Klemme während des Anhebens zwischen der ersten Position und der zweiten Position mit der oberen Oberfläche (52) der Leiterplatte (50) in Eingriff steht, so dass die Leiterplatte (50) zwischen der oberen Klemme und der Hubeinrichtung sicher gehalten wird.

14. Verfahren nach Anspruch 13, wobei der Bereitstellungsschritt den Schritt umfasst:
Bereitstellen der Leiterplatte (50) auf ersten und zweiten Transport-Schienenelementen (112, 132).

15. Verfahren nach Anspruch 14, wobei die Hebeeinrichtung erste und zweite Hubschienen (154, 164) umfasst, und weiter vor dem Bereitstellungsschritt die Schritte umfasst:
Einstellen eines ersten Abstands zwischen den ersten und zweiten Transport-Schienenelementen (112, 132); und
Gleichzeitig Einstellen eines zweiten Abstands zwischen den ersten und zweiten Hubschienen (154, 164).

16. Verfahren nach Anspruch 13, welches weiter nach dem Hebeschritt den Schritt umfasst:
Durchführen eines Herstellungsbetriebs auf der Leiterplatte (50).

17. Verfahren nach Anspruch 16, welches weiter nach dem Herstellungsschritt, den Schritt umfasst:
Absenken der Leiterplatte (50) in die erste Position.

18. Verfahren nach Anspruch 17, welches gleichzeitig mit dem Absenkeschritt weiter den Schritt umfasst:
Freigeben der oberen Klemme von der Hubeinrichtung.

19. Verfahren zur automatischen Durchführung von Herstellungsprozessen mehrerer Leiterplatten (50), welches die Schritte umfasst:
(a) Durchführen des Verfahrens nach Anspruch 13, wobei die Leiterplatte (50) auf einer Transporteinrichtung zu einem bestimmten Ort in der Station befördert wird;
(b) Durchführen eines Herstellungsprozesses auf der oberen Oberfläche (52) der Leiterplatte (50);
(c) Absenken der Leiterplatte (50) auf die Transporteinrichtung, wobei die obere Klemme die Leiterplatte (50) während des Absenkens freigibt;
(d) Transportieren der Leiterplatte (50) weg von der Station; und
(e) Wiederholen der Schritte (a) bis (d) automatisch bei nachfolgenden Leiterplatten (50).

## Revendications

1. Dispositif de maintien de carte de CI (circuit imprimé) pour maintenirune carte (50) de CI, comprenant:
un membre de base (142) déplaçable entre une première position et une deuxième position;
un premier rail de levage (154), convenant à lever et venir en prise avec la carte de CI (50), et monté sur le membre de base;
un deuxième rail de levage (164), convenant à venir en prise et lever la carte de CI (50), et s'étendant de manière sensiblement parallèle au premier rail de levage (154);
**caractérisé en ce que** le dispositif de maintien de carte de CI comprend en outre :
un premier membre de maintien (179) relié de manière mobile au premier rail de levage (154); et un deuxième membre de maintien (191) relié de manière mobile au deuxième rail de levage (132), dans lequel,
lorsque le membre de base est dans la première position, le premier membre de maintien (179) est disposé à l'écart du premier rail de levage (154) et le deuxième membre de maintien
(191) est disposé à l'écart du deuxième rail de levage (164), de manière à recevoir entre eux la carte (50) de CI, et, lorsque le membre de base (142) est dans la deuxième position, le premier membre de maintien (179) est disposé à proximité du premier rail de levage (154)et le deuxième membre de maintien (191) est disposé à proximité du deuxième rail de levage (164), de sorte que la carte (50) de CI est maintenue par, et entre, le premier membre de maintien (179) et le rail de levage (154) et entre le deuxièmemembre de maintien (191) et le deuxième rail de levage (164).

2. Dispositif de maintien de carte de CI selon la revendication 1, comprenant en outre :
un premier support (170a) de membre de maintien, monté sur le premier rail de levage (154), dans lequel le premier membre de maintien (179) est relié de manière mobile au premier support (170a) de membre de maintien.

3. Dispositif de maintien de carte de CI selon la revendication 1, comprenant en outre :
un deuxième support (184a) de membre de maintien, monté sur le deuxième rail de levage (164), dans lequel le deuxième membre de maintien (179) est relié de manière mobile au deuxième support (184a) de membre de maintien.

4. Dispositif de maintien de carte de CI selon la revendication 1, dans lequel le premier membre de maintien (179) est mobile verticalement par rapport au membre de base (142).

5. Dispositif de maintien de carte de CI selon la revendication 1, dans lequel le membre de base (142) comprend un plan (P) et le premier rail de levage (154) est mobile sur le plan (P).

6. Equipement de maintien de carte de CI, comprenant
le dispositif de maintien de carte de CI selon l'une des revendications 1 à 5, et un ensemble de convoyeur de carte de CI à rail, incluant :
un premier membre de rail de convoyeur allongé (112), s'étendant de manière sensiblement parallèle au premier rail de levage (154); et
un deuxième membre de rail de convoyeur allongé (132), espacé du premier, et s'étendant de manière sensiblement parallèle au premier membre de rail de convoyeur (112);
dans lequel, lorsque le membre de base (142) est dans la première position, le premier rail de levage (142) est disposéen-dessous dupremier membre de rail de convoyeur (112), et le deuxième rail de levage (164) est disposé en-dessous du deuxième membre de rail de convoyeur (132), et, lorsque le membre de base (142) est dans la deuxième position, le premier rail de levage (142) est disposé au-dessus du premier membre de rail de convoyeur (112), et le deuxième rail de levage (164) est disposé au-dessus du deuxième membre de rail de convoyeur (132).

7. Equipement de maintien de carte de CI selon la revendication 6, dans lequel, lorsque le membre de base (142) est dans la première position, le premier membre de maintien (179) est disposé à proximité du premier membre de rail de convoyeur (112), et, lorsque le membre de base (142) est dans la deuxième position, le premier membre de maintien (179) est disposé à distance du premier membre de rail de convoyeur (112).

8. Equipement de maintien de carte de CI selon la revendication 7, en dépendance de la revendication 2, dans lequel le premier membre de rail de convoyeur (112) est disposé entre le premier support (170a) de membre de maintien, et le deuxième membre de rail de convoyeur (132).

9. Equipement de maintien de carte de CI selon la revendication 6, dans lequel le premier rail de levage (154) est disposé entre le premier et le deuxième membre de rail de convoyeur (112,132).

10. Equipement de maintien de carte de CI selon la revendication 6, dans lequel le premier membre de rail de convoyeur (112) est mobile dans une première direction et le premier rail de levage (154) est mobile avec le premier membre de rail de convoyeur (112).

11. Equipement de maintien de carte de CI selon la revendication 6, dans lequel le premier membre de maintien (179) est mobile verticalement par rapport au premier membre de rail de convoyeur (112).

12. Equipement de maintien de carte de CI selon la revendication 6, dans lequel le premier membre de maintien (179) est mobile verticalement par rapport au premier rail de levage (154).

13. Procédé de fixation d'une carte (50) de CI à une fixation, comprenant les étapes de :
Fourniture d'une carte (50) de CI ayant une face supérieure (52) et une face inférieure (54);
Acheminement de la carte (50) de CI en un emplacement déterminé;
Prise de la face inférieure de la carte (50) de CI avec un dispositif de levage, et levage de la carte (50) de Cl d'une première position à une deuxième position;
Caractérisé par:
la fourniture d'un dispositif de maintien supérieur, pour venir en prise sur la face supérieure de la carte (50) de CI;le dispositif de maintien supérieur étant disposé à l'écart de la face supérieure (52) de la carte (50) de CI dans la première position, et
le dispositif de maintien supérieur venant en prise avec la face supérieure (52) de la carte (50) de CI lors du levage entre la première et la deuxième position, de sorte que la carte (50) de CI est solidement maintenue entre le dispositif de maintien supérieur et le dispositif de levage.

14. Procédé selon la revendication 13, dans lequel l'étape de fourniture comprend l'étape de:
fourniture de la carte (50) de CI sur des premier et deuxième membres de rail de convoyeur (112, 132).

15. Procédé selon la revendication 14, dans lequel le dispositif de levage comprend des premier et second rails de levage (154, 164), et comprenant en outre, avant l'étape de fourniture, les étapes consistant à :
ajuster un premier espacement entre les premier et deuxième membres de rail de convoyeur (112, 132), et
ajuster simultanément un deuxième espacement entre les premier et deuxièmes rails de levage (154,164).

16. Procédé selon la revendication 13, comprenant en outre, après l'étape de levage, l'étape de:
réalisation d'une opération de fabrication sur la carte (50) de Cl.

17. Procédé selon la revendication 16, comprenant en outre, après l'étape de fabrication, l'étape de :
abaissement de la carte (50) de CI jusqu'à la première position.

18. Procédé selon la revendication 17, comprenant en outre, simultanément à l'étape d'abaissement, l'étape de
relâchement le dispositif de maintien supérieur du dispositif de levage.

19. Procédé de mise en oeuvre automatique de processus de fabrication sur une pluralité de cartes (50) de CI, comprenant les étapes de:
(a) mise en oeuvre d'un procédé selon la revendication 13, dans lequel la carte (50) de CI est acheminée sur un convoyeur en un emplacement déterminé à un poste;
(b) mise en oeuvre d'un processus de fabrication sur une face supérieure (52) de la carte (50) de CI;
(c) abaissement de la carte (50) de CI vers le convoyeur, dans lequel le dispositif de maintien supérieur libère la carte (50) de CI lors de l'abaissement,
(d) transport de la carte(50) de CI à l'écart du poste, et
(e) répétition des étapes (a) à (d) automatiquement sur des cartes (50) de Cl subséquentes.
